# EUROPEAN PATENT APPLICATION

(11) **EP 4 231 510 A1**
(43) Date of publication of application: **23.08.2023**
(21) Application number: 22815321.9
(22) Date of filing: 01.06.2022
(51) Int. Cl.: H02M 1/00

(54) **CURRENT SAMPLING CIRCUIT APPLIED TO BIDIRECTIONAL AC-DC CONVERTER**

(30) Priority: 03.06.2021 CN 202110616916
(71) Applicant: ZHEJIANG EV-TECH CO., LTD., Huzhou, Zhejiang 310012 (CN)
(72) Inventor: HAO, Shiqiang, Huzhou, Zhejiang 310012 (CN); SHI, Hongbo, Huzhou, Zhejiang 310012 (CN); TAO, Sili, Huzhou, Zhejiang 310012 (CN); HE, Qiang, Huzhou, Zhejiang 310012 (CN); PING, Dinggang, Huzhou, Zhejiang 310012 (CN)
(74) Representative: dompatent von Kreisler Selting Werner - Partnerschaft von Patent- und Rechtsanwälten mbB
(86) International application number: PCT/CN2022/096654
(87) International publication number: WO 2022/253279

(57) **Abstract**

The present invention provides a current sampling circuit applied to a bidirectional AC-DC converter, including: a totem-pole PFC circuit, a first current detection circuit, a second current detection circuit, and a controller. The totem-pole PFC circuit is provided with a fast-switch bridge arm formed by a switch S1 and a switch S2 connected in series. By adding two current transformers to the fast-switch bridge arm of the totem-pole PFC circuit, the present invention meets the requirements of bidirectional AC/DC for current detection with software sampling and control time sequence, which has the advantages of high precision, high bandwidth, low delay and low cost.

## Description

This application claims the priority of the Chinese patent application No. 202110616916.X, "CURRENT SAMPLING CIRCUIT APPLIED TO BIDIRECTIONAL AC-DC CONVERTER", submitted to the Chinese Patent Office on June 03, 2021. The entire content of this application is incorporated by reference.

### FIELD OF TECHNOLOGY

The present invention relates to the technical filed of current sampling, and in particular, to a current sampling circuit applied to a bidirectional AC-DC converter.

### BACKGROUND

With the explosive growth of new energy vehicles, the demand for on-board chargers is also greatly increased. Generally, the on-board charger has high requirements on the power factor and current harmonics of the grid side, so the front AC/DC of the on-board charger needs a current detection apparatus to meet the control requirements of the power factor and current harmonics of the grid side. With reference to the China Patent Public No. CN206379716U, electric vehicle, on-board charger, and its overcurrent protection circuit, on-board charger includes AC/DC converter and DC/DC converter. AC/DC converter and DC/DC converter both adopt optocoupler-driven SiC switches. The over-current protection circuit includes: a current detection unit, configured to output a current detection value by detecting a current of the output end of the DC/DC converter; an over-current protection unit, configured to output an over-current protection signal; and a controlling unit, configured to turn off a control signal output channel of the SiC switches when receiving the over-current protection signal, to enable the AC/DC converter and the DC/DC converter to stop working. The over-current protection circuit may quickly trigger an over-current protection function when an over-current fault occurs in the vehicle charger. With reference to the China Patent Public No. CN103809007A, the bridgeless PFC circuit inductance current sampling apparatus and method, including a first sampling unit, a second sampling unit, and a third sampling unit. The bridgeless PFC circuit inductance current sampling apparatus is connected to a bridgeless PFC circuit. The first sampling unit is connected to a first switch of the bridgeless PFC circuit in series, and is configured to sample a current of the first switch to obtain a first sampling signal V1. The second sampling unit is connected to a second switch of the bridgeless PFC circuit in series, and is configured to sample a current of the second switch to obtain a second sampling signal V2. One end of the third sampling unit is connected to a ground terminal of the bridgeless PFC circuit, and the other end is connected to a negative output end of a PFC capacitor of the bridgeless PFC circuit, and is configured to sample a current flowing through a step-up diode of the bridgeless PFC circuit to obtain a third sampling signal V3. However, the above current detector can not meet the high precision, high bandwidth, low delay, low cost and other requirements.

### SUMMARY

The present invention solves the problem of low accuracy of existing current detector and provide a current sampling circuit applied to a bidirectional AC-DC converter. By adding two current transformers to the fast-switch bridge arm of the totem-pole PFC circuit, the present invention meets the requirements of bidirectional AC/DC for current detection with software sampling and control time sequence, which has the advantages of high precision, high bandwidth, low delay and low cost.

To achieve the foregoing objectives, according to a first aspect of the current invention the following technical solutions are provided.

A current sampling circuit applied to a bidirectional AC-DC converter, including:
a totem-pole PFC circuit, comprising a fast-switch bridge arm formed by a switch S1 and a switch S2 connected in series;
a first current detection circuit, comprising a first current transformer CT, a first demagnetization circuit, and a first current sampling circuit that are successively connected, where the first current sampling circuit outputs a first sampling signal VS1, the first current transformer CT is a transformer T1, and a primary winding of the transformer T1 is connected in series with the switch S1;
a second current detection circuit, comprising a second current transformer CT, a second demagnetization circuit, and a second current sampling circuit that are successively connected, where the second current sampling circuit outputs a second sampling signal VS2, the second current transformer CT is a transformer T2, and a primary winding of the transformer T2 is connected in series with the switch S2; and
a controller, connecting the first current sampling circuit and the second current sampling circuit to receive the first sampling signal VS1 and the second sampling signal VS2, wherein in one switching cycle, the controller obtains sampling points Sa1, Sa2, Sa3, and Sa4 and four corresponding sampling values by sampling the first current detection circuit and the second current detection circuit for one time at a driving midpoint of the switches S1 and S2.

Optionally,, the controller performs the following steps:
determining a sampling value of an active switch in a case that the transformer T1 and the transformer T2 are connected in dotted terminals, and the active switch is the switch S2 in a case that an AC voltage is in a positive half cycle, choosing the sampling value of Sa2 as a sampling current value in a case that the sampling value of Sa2 is greater than the sampling value of Sa4; and choosing the sampling value of Sa3 as a sampling current value in a case that the sampling value of Sa2 is less than the sampling value of Sa4; the active switch is the switch S1 in a case that an AC voltage is in a negative half cycle, choosing the sampling value of Sa3 as a sampling current value in a case that the sampling value of Sa3 is greater than the sampling value of Sa1; choosing the sampling value of Sa2 as a sampling current value in a case that the sampling value of Sa3 is less than the sampling value of Sa1;
determining a sampling value of a freewheeling switch in a case that the transformer T1 and the transformer T2 are connected in non-dotted terminals, and the freewheeling switch is the switch S1 in a case that an AC voltage is in a positive half cycle, choosing the sampling value of Sa3 as a sampling current value in a case that the sampling value of Sa3 is greater than the sampling value of Sa1; choosing the sampling value of Sa2 as a sampling current value in a case that the sampling value of Sa3 is less than the sampling value of Sa1; the freewheeling switch is the switch S2 in a case that an AC voltage is in a negative half cycle, choosing the sampling value of Sa2 as a sampling current value in a case that the sampling value of Sa2 is greater than the sampling value of Sa4; and choosing the sampling value of Sa3 as a sampling current value in a case that the sampling value of Sa2 is less than the sampling value of Sa4. By adding two current transformers to the fast-switch bridge arm of the totem-pole PFC circuit to meet the general control requirements and overcurrent protection requirements under abnormal working conditions, the present invention meets the requirements of bidirectional AC/DC for current detection with software sampling and control time sequence, which has the advantages of high precision, high bandwidth, low delay and low cost.

Optionally,, both of the first demagnetization circuit and the second demagnetization circuit comprising a diode D1, a PMOSQ1, a diode D2, and a resistor R1. in the first demagnetization circuit, the source of the PMOSQ1, the positive electrode of the diode D2, and one end of the resistor R1 are connected to the positive electrode of the diode D1; the drain of the PMOSQ1, the negative electrode of the diode D2, and the other end of the resistor R1 are connected to one end of the secondary winding of the transformer T1; and the negative electrode of the diode D1 is connected to the other end of the secondary winding of the transformer T1; and in the second demagnetization circuit, the source of the PMOSQ1, the positive electrode of the diode D2, and one end of the resistor R1 are connected to the positive electrode of the diode D1; the drain of the PMOSQ1, the negative electrode of the diode D2, and the other end of the resistor R1 are connected to one end of the secondary winding of the transformer T2; and the negative electrode of the diode D1 is connected to the other end of the secondary winding of the transformer T2.

Optionally,, both of the first current sampling circuit and the second current sampling circuit comprising a diode D3, a resistor R2, and a resistor R3. One end of the resistor R2 and one end of the resistor R3 are connected to the negative electrode of the diode D3. in the first current sampling circuit, the other end of the resistor R2 and the other end of the resistor R3 are connected to one end of the secondary winding of the transformer T1, and the positive electrode of the diode D3 is connected to the other end of the secondary winding of the transformer T1, and in the second current sampling circuit, the other end of the resistor R2 and the other end of the resistor R3 are connected to one end of the secondary winding of the transformer T2, and the positive electrode of the diode D3 is connected to the other end of the secondary winding of the transformer T2.

Optionally,, the totem-pole PFC circuit comprising an inductor L1, a switch S3, a switch S4, a capacitor Cbulk, and an alternating current power supply AC. One end of the alternating current power supply AC is connected to one end of the inductor L 1, and the other end of the inductor L1 is connected to the source of the switch S1 and the drain of the switch S2. The drain of the switch S1 is connected to the drain of the switch S3 and one end of the capacitor Cbulk, and the other end of the capacitor Cbulk is connected to the source of the switch S2 and the source of the switch S4. The source of the switch S3 and the drain of the switch S4 are connected to the other end of the alternating current power supply AC, and the sampling current value is used as a current value of the inductor L1.

Optionally,, an AC voltage detection circuit is further provided, and the AC voltage detection circuit is connected to two ends of the alternating current power supply AC to detect voltages at the two ends of the alternating current power supply AC, and transmit the voltages at the two ends of the alternating current power supply AC to the controller.

Optionally,, a bus voltage detection circuit is further provided, and the bus voltage detection circuit is connected to two ends of the capacitor Cbulk to detect voltages at the two ends of the capacitor Cbulk, and transmit the voltages at the two ends of the capacitor Cbulk to the controller.

Optionally,, the current sampling circuit operates in a current sampling mode, and the secondary winding of the current transformer, the diode D3, and the current sampling unit form a current loop.

Optionally,, the current sampling circuit operates in a bypass mode, and the secondary winding of the current transformer, the PMOSQ1, and diode D1 form a current loop.

Optionally,, the current sampling circuit operates in a demagnetization mode, and the secondary winding of the current transformer, the resistor R1, and diode D1 form a current loop.

The beneficial effects of the present invention are that: by adding two current transformers to the fast-switch bridge arm of the totem-pole PFC circuit to meet the general control requirements and overcurrent protection requirements under abnormal working conditions, the present invention meets the requirements of bidirectional AC/DC for current detection with software sampling and control time sequence, which has the advantages of high precision, high bandwidth, low delay and low cost.

### BRIEF DESCRIPTION OF THE DRAWINGS

FIG. 1 is a totem-pole PFC circuit diagram according to an embodiment.
FIG. 2 is a schematic diagram of a circuit when the primary side of the current transformer CT and the secondary side of the current transformer CT are connected in dotted terminals according to an embodiment.
FIG. 3 is a schematic diagram of a circuit when the primary side of the current transformer CT and the secondary side of the current transformer CT are connected in non-dotted terminals according to an embodiment.
FIG. 4 is a schematic diagram of a current flow of a totem-pole PFC circuit when a switch S2 and a switch S4 are turned on according to an embodiment.
FIG. 5 is a schematic diagram of a current flow of a totem-pole PFC circuit when a switch S 1 and a switch S4 are turned on according to an embodiment.
FIG. 6 is a diagram of a current flow of a second current detection circuit when the primary side of the current transformer CT and the secondary side of the current transformer CT are connected in dotted terminals and a switch S2 and a switch S4 are turned on according to an embodiment.
FIG. 7 is a diagram of a current flow of a first current detection circuit when the primary side of the current transformer CT and the secondary side of the current transformer CT are connected in dotted terminals and a switch S1 and a switch S3 are turned on according to an embodiment.
FIG. 8 is a schematic diagram of a sampling waveform when the primary side of the current transformer CT and the secondary side of the current transformer CT are connected in dotted terminals according to an embodiment.
FIG. 9 is a schematic diagram of a current flow of a totem-pole PFC circuit when a switch S1 and a switch S3 are turned on according to an embodiment.
FIG. 10 is a schematic diagram of a current flow of a totem-pole PFC circuit when a switch S2 and a switch S3 are turned on according to an embodiment.
FIG. 11 is a diagram of a current flow of a second current detection circuit when the primary side of the current transformer CT and the secondary side of the current transformer CT are connected in dotted terminals and a switch S1 and a switch S3 are turned on according to an embodiment.
FIG. 12 is a diagram of a current flow of a first current detection circuit when the primary side of the current transformer CT and the secondary side of the current transformer CT are connected in dotted terminals and a switch S2 and a switch S4 are turned on according to an embodiment.
FIG. 13 is a diagram of a current flow of a first current detection circuit when the primary side of the current transformer CT and the secondary side of the current transformer CT are connected in non-dotted terminals and a switch S2 and a switch S4 are turned on according to an embodiment.
FIG. 14 is a diagram of a current flow of a second current detection circuit when the primary side of the current transformer CT and the secondary side of the current transformer CT are connected in non-dotted terminals and a switch S2 and a switch S4 are turned on according to an embodiment.
FIG. 15 is a diagram of a current flow of a first current detection circuit when the primary side of the current transformer CT and the secondary side of the current transformer CT are connected in non-dotted terminals and a switch S 1 and a switch S3 are turned on according to an embodiment.
FIG. 16 is a diagram of a current flow of a second current detection circuit when the primary side of the current transformer CT and the secondary side of the current transformer CT are connected in non-dotted terminals and a switch S 1 and a switch S3 are turned on according to an embodiment.
FIG. 17 is a schematic diagram of a sampling waveform when the primary side of the current transformer CT and the secondary side of the current transformer CT are connected in non-dotted terminals according to an embodiment.
FIG. 18 is a schematic diagram of an ideal current direction when AC-DC works in a backward direction and an AC voltage is in a positive half cycle according to an embodiment.
FIG. 19 is a diagram of a waveform when AC-DC works in a backward direction and an AC voltage is in a positive half cycle according to an embodiment.
FIG. 20 is a schematic diagram of an ideal current direction when AC-DC works in a backward direction and an AC voltage is in a negative half cycle according to an embodiment.
FIG. 21 is a diagram of a waveform when AC-DC works in a backward direction and an AC voltage is in a negative half cycle according to an embodiment.
FIG. 22 is a diagram of a waveform of the positive half cycle when the primary side of the current transformer CT and the secondary side of the current transformer CT are connected in non-dotted terminals and AC-DC works in a backward direction according to an embodiment.
FIG. 23 is a diagram of a waveform of the negative half cycle when the primary side of the current transformer CT and the secondary side of the current transformer CT are connected in non-dotted terminals and AC-DC works in a backward direction according to an embodiment.

### DESCRIPTION OF THE EMBODIMENTS

### Embodiments:

CT1 in the accompanying drawings and embodiments refers to a first current detection circuit, and CT2 refers to a second current detection circuit. This embodiment provides a current sampling circuit applied to a bidirectional AC-DC converter, including the following components.

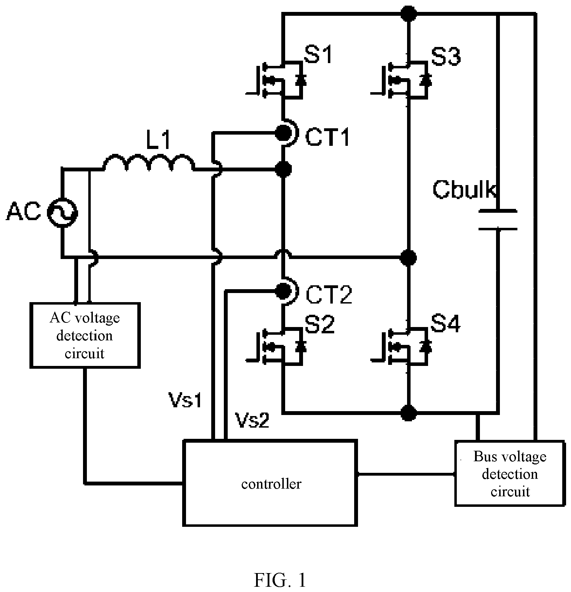

Referring to FIG. 1, a totem-pole PFC circuit includes a switch S1, a switch S2, an inductor L1, a switch S3, a switch S4, a capacitor Cbulk, and an alternating current power supply AC. The switch S1 and the switch S2 are connected in series to form a fast-switch bridge arm. One end of the alternating current power supply AC is connected to one end of the inductor L1, and the other end of the inductor L1 is connected to the source of the switch S1 and the drain of the switch S2. The drain of the switch S1 is connected to the drain of the switch S3 and one end of the capacitor Cbulk, and the other end of the capacitor Cbulk is connected to the source of the switch S2 and the source of the switch S4. The source of the switch S3 and the drain of the switch S4 are connected to the other end of the alternating current power supply AC. The current value of the inductor L1 may be used as a sampling current value. The switch S1 and the switch S2 of the fast-switch bridge arm work in a high frequency switching state, and the switch S3 and switch S4 work in a power frequency switching state.

A first current detection circuit includes a first current transformer CT, a first demagnetization circuit, and a first current sampling unit that are successively connected, where the first current sampling unit outputs a first sampling signal VS1, the first current transformer CT is a transformer T1, and a primary winding of the transformer T1 is connected in series with the switch S 1. A second current detection circuit includes a second current transformer CT, a second demagnetization circuit, and a second current sampling unit that are successively connected, where the second current sampling unit outputs a second sampling signal VS2, the second current transformer CT is a transformer T2, and a primary winding of the transformer T2 is connected in series with the switch S2.

A controller connects the first current sampling circuit and the second current sampling circuit to receive the first sampling signal VS1 and the second sampling signal VS2, wherein in one switching cycle, the controller obtains sampling points Sa1, Sa2, Sa3, and Sa4 and four corresponding sampling values by sampling the first current detection circuit and the second current detection circuit for one time at the driving midpoint of the switches S1 and S2; and Sa1 and Sa3 correspond to the first current detection circuit, and Sa2 and Sa4 correspond to the second current detection circuit. The controller performs the following steps:
determining a sampling value of an active switch in a case that the transformer T1 and the transformer T2 are connected in dotted terminals, and the active switch is switch S2 in a case that the AC voltage is in a positive half cycle, choosing the sampling value of Sa2 as a sampling current value in a case that the sampling value of Sa2 is greater than the sampling value of Sa4; and choosing the sampling value of Sa3 as a sampling current value in a case that the sampling value of Sa2 is less than the sampling value of Sa4; the active switch is switch S1 in a case that the AC voltage is in a negative half cycle, choosing the sampling value of Sa3 as a sampling current value in a case that the sampling value of Sa3 is greater than the sampling value of Sa1; choosing the sampling value of Sa2 as a sampling current value in a case that the sampling value of Sa3 is less than the sampling value of Sa1;
determining a sampling value of a freewheeling switch in a case that the transformer T1 and the transformer T2 are connected in non-dotted terminals, and the freewheeling switch is switch S1 in a case that the AC voltage is in a positive half cycle, choosing the sampling value of Sa3 as a sampling current value in a case that the sampling value of Sa3 is greater than the sampling value of Sa1; choosing the sampling value of Sa2 as a sampling current value in a case that the sampling value of Sa3 is less than the sampling value of Sa1; the freewheeling switch is switchS2 in a case that the AC voltage is in a negative half cycle, choosing the sampling value of Sa2 as a sampling current value in a case that the sampling value of Sa2 is greater than the sampling value of Sa4; and choosing the sampling value of Sa3 as a sampling current value in a case that the sampling value of Sa2 is less than the sampling value of Sa4.

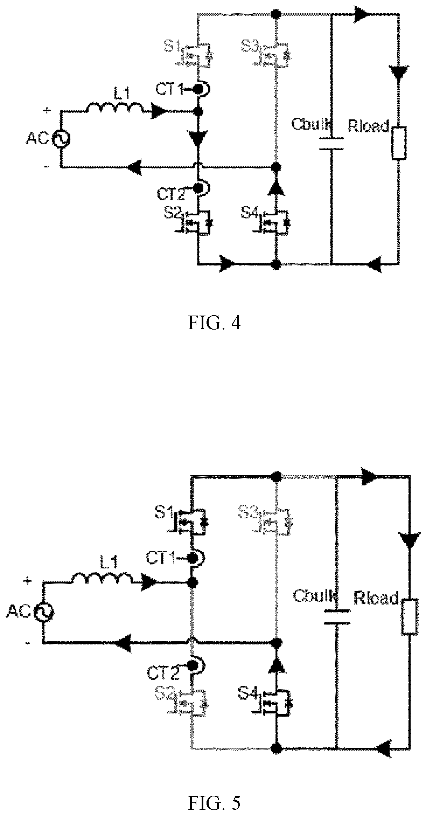

Referring to FIG. 4, if the AC input is in the positive half cycle, that is the upper part is positive and the lower part is negative, the switch S4 keeps on, and the switch S2 performs in switching mode. When the switch S2 is turned on, the main power current is shown in FIG. 4; and when the switch S2 is off, the main power current is shown in FIG. 5. In this case, the switch S2 is active switch, and the switch S1 may not perform in switching mode, and in this case, the power current in FIG. 5 flows through a body diode of the switch S1. The switch S1 may also perform in switching mode, and the switching sequence is complementary to that of the switch S2. In this case, the power current in FIG. 5 flows through the channel of the switch S1, which is a common synchronous rectification mode. In this case, the switch S1 is a freewheeling switch.

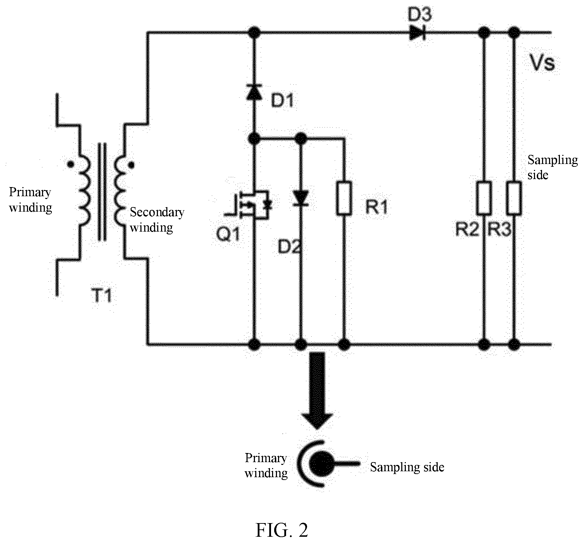

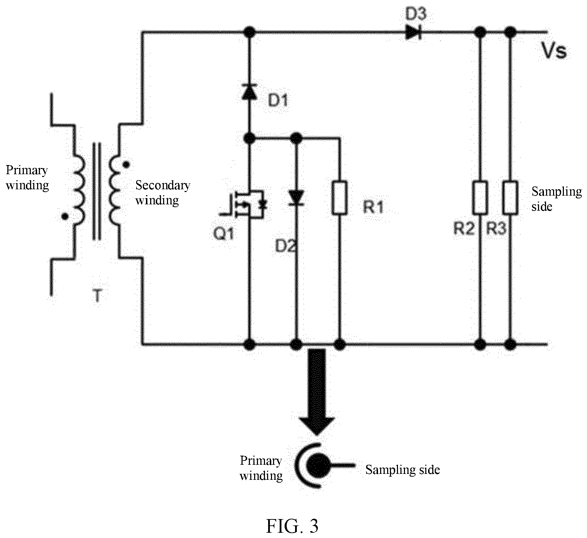

Referring to FIG. 2 and FIG. 3, both of the first demagnetization circuit and the second demagnetization circuit include a diode D1, a PMOSQ1, a diode D2, and a resistor R1. In the first demagnetization circuit, the source of the PMOSQ1, the positive electrode of the diode D2, and one end of the resistor R1 are connected to the positive electrode of the diode D1; the drain of the PMOSQ1, the negative electrode of the diode D2, and the other end of the resistor R1 are connected to one end of the secondary winding of the transformer T1; and the negative electrode of the diode D1 is connected to the other end of the secondary winding of the transformer T1. In the second demagnetization circuit, the source of the PMOSQ1, the positive electrode of the diode D2, and one end of the resistor R1 are connected to the positive electrode of the diode D1; the drain of the PMOSQ1, the negative electrode of the diode D2, and the other end of the resistor R1 are connected to one end of a secondary winding of the transformer T2; and the negative electrode of the diode D1 is connected to the other end of the secondary winding of the transformer T2.

Both of the first current sampling unit and the second current sampling unit include a diode D3, a resistor R2, and a resistor R3. One end of the resistor R2 and one end of the resistor R3 are connected to the negative electrode of the diode D3. In the first current sampling circuit, the other end of the resistor R2 and the other end of the resistor R3 are connected to one end of the secondary winding of the transformer T1, and the positive electrode of the diode D3 is connected to the other end of the secondary winding of the transformer T1. In the second current sampling circuit, the other end of the resistor R2 and the other end of the resistor R3 are connected to one end of the secondary winding of the transformer T2, and the positive electrode of the diode D3 is connected to the other end of the secondary winding of the transformer T2.

According to this embodiment, an AC voltage detection circuit is further provided, and the AC voltage detection circuit is connected to two ends of the alternating current power supply to detect voltages at the two ends of the alternating current power supply, and transmit the voltages at the two ends of the alternating current power supply to the controller.

According to this embodiment, a bus voltage detection circuit is further included, and the bus voltage detection circuit is connected to two ends of the capacitor Cbulk to detect voltages at the two ends of the capacitor Cbulk, and transmit the voltages at the two ends of the capacitor Cbulk to the controller.

When the current sampling circuit operates in a current sampling mode, the secondary winding of the current transformer, the diode D3, and the current sampling unit form a current loop. When the current sampling circuit operates in a bypass mode, the secondary winding of the current transformer, the PMOSQ1, and diode D1 form a current loop. When the current sampling circuit operates in a demagnetization mode, the secondary winding of the current transformer, the resistor R1, and diode D1 form a current loop.

The working principle of this embodiment is explained below.

Referring to FIG. 2, when the primary side of the current transformer CT and the secondary side of the current transformer CT are connected in dotted terminals , for example, the AC-DC works in a forward direction, that is, AC voltage is transferred to be DC voltage, and when the voltage of AC is in the positive half cycle, that is the upper part is positive and the lower part is negative, in an idea case, a current direction of AC is to be shown in FIG. 4 and FIG. 5.

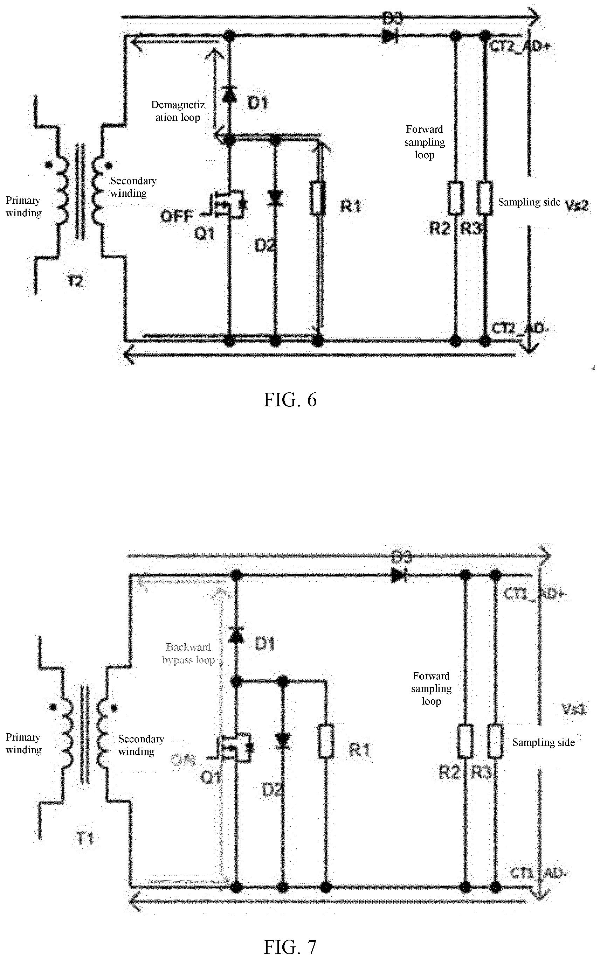

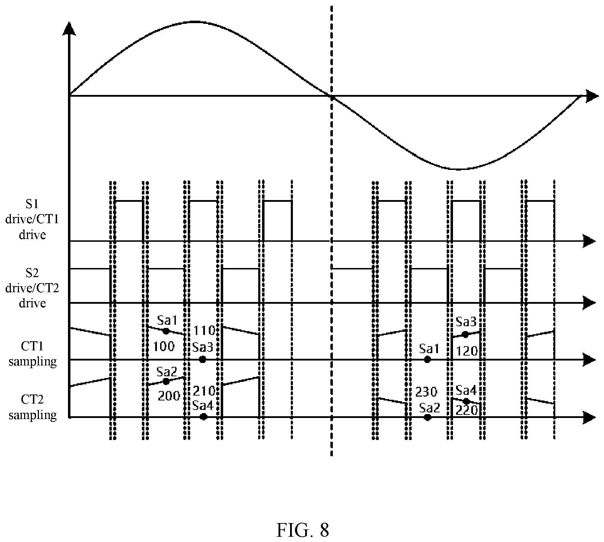

Specifically, when the switch S2 and the switch S4 are turned on, as the current direction shown in FIG. 4, when a primary current of the current transformer CT flows in from the dotted terminal of CT2, a secondary current of CT2 flows out from the dotted terminal, and a current path of CT2 shown as the outermost arrow in FIG. 6, that is, the current flows through a forward sampling loop. A sampling resistor outputs a sampling signal VS2 representing a power current flowing through the switch S2, and for the sampling output signal, reference may be made to a waveform 200 of "CT2 sampling" shown in FIG. 8, that is, CT2 works in a forward sampling mode, and in this case, the transformer T1 of CT2 is excited forward. In this case, no current flows through the primary side of CT1, and an excitation current generated by the transformer T1 flows through the secondary side of CT1, and the current path is shown as the outermost arrow in FIG. 7, that is, the current flows through the forward sampling loop. The sampling resistor outputs a sampling signal VS1 representing the excitation current flowing through the transformer T1, and for the sampling output signal, reference may be made to a waveform 100 of "CT1 sampling" shown in FIG. 8. As shown in FIG. 8, the sampling signal VS2 representing the power current flowing through the switch S2 is gradually increased, such as the waveform 200. Because there is no excitation from the primary side, the excitation current generated by CT1 gradually decreases, as shown in the waveform 100.

Then, the primary current is commutated, and the switch S1 and the switch S4 are turned on. As the current direction shown in FIG. 5, the main power does not flow through the switch S2. In this case, no current flows through the primary side of CT2, and PMOSQ1 in CT2 is controlled to turn off. The secondary current of CT2 flows a demagnetization loop, performs backward demagnetization shown as the inner side arrow in FIG. 6, and quickly demagnetizes by high resistance R1=10kΩ. In this case, the secondary current of CT2 does not flow through the sampling resistor, and therefore, an output value of the sampling resistor is 0, as the waveform 210 of "CT2 sampling" shown in FIG. 8, that is, CT2 works in a demagnetization mode. However, in this case, when the primary current of CT1 flows out from the dotted terminal, and the secondary current of CT1 flows out from the dotted terminal. If CT1 flows in a backword demagnetization loop, the high resistance R1 of the demagnetization loop is relatively large, which will quickly cause backward magnetic saturation of transformer T1. Therefore, PMOSQ1 needs to be turned on to enable the secondary current to flow through a backward bypass loop formed by PMOSQ1 and the diode D1, thereby achieving backward bypass, bypassing the sampling resistor, and enabling the sampling output zero, as the waveform 110 shown in FIG. 8. During the working process, the switch S2 is an active switch, and the switch S1 is a freewheeling switch. The sampling value of Sa2 is chosen as a sampling current value in a case that the sampling value of Sa2 is greater than the sampling value of Sa4. The sampling value of Sa3 is chosen as a sampling current value in a case that the sampling value of Sa2 is less than the sampling value of Sa4.

When in the positive half cycle, the sampling signal outputted by the sampling resistor of CT2 is a power current value.

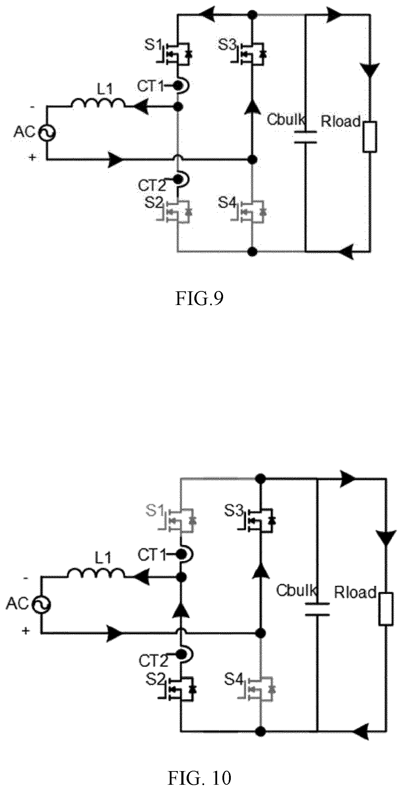

For example, the AC-DC works in a forward direction, that is, AC voltage is transferred to be DC voltage, and when the voltage of AC is in the negative half cycle, that is the lower part is positive and the upper part is negative, in an idea case, a current direction of AC is to be shown in FIG. 9 and FIG. 10.

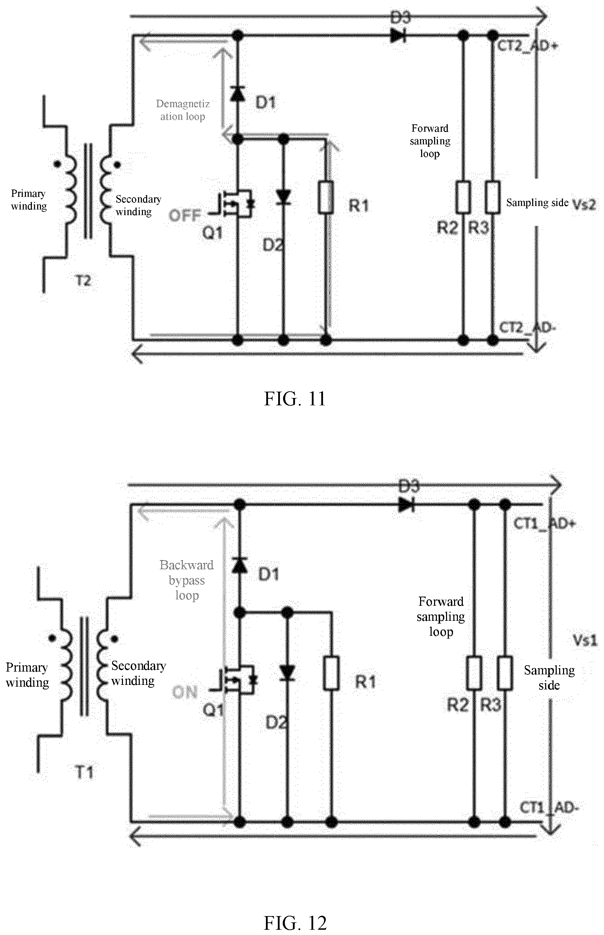

Specifically, when the switch S1 and the switch S3 are turned on, as the current direction shown in FIG. 9, when a primary current of the current transformer CT flows in from the dotted terminal of CT1, a secondary current of CT1 flows out from the dotted terminal, and a current path of CT1 shown as the outermost arrow in FIG. 11, that is, the current flows through a forward sampling loop. A sampling resistor outputs a sampling signal VS1 representing a power current flowing through the switch S1, and for the sampling output signal, reference may be made to a waveform 120 of "CT1 sampling" shown in FIG. 8, that is, CT1 works in a forward sampling mode, and in this case, the transformer T1 of CT1 is excited forward. In this case, no current flows through the primary side of CT2, and an excitation current generated by the transformer T2 flows through the secondary side of CT2, and the current path is shown as the outermost arrow in FIG. 12, that is, the current flows through the forward sampling loop. The sampling resistor outputs a sampling signal VS2 representing an excitation current flowing through the transformer T2, and for the sampling output signal, reference may be made to a waveform 220 of "CT2 sampling" shown in FIG. 8. As shown in FIG. 8, the sampling signal VS1 representing the power current flowing through the switch S1 is gradually increased, such as the waveform 120. Because there is no excitation from the primary side, the excitation current generated by CT2 gradually decreases, as shown in the waveform 220.

Then, the primary current is commutated, and the switch S2 and the switch S3 are turned on. As the current direction shown in FIG. 10, the main power does not flow through the switch S1. In this case, no current flows through the primary side of CT1, and PMOSQ1 in CT1 is controlled to turn off. The secondary current of CT1 flows a demagnetization loop, performs backward demagnetization shown as the inner side arrow in FIG. 12, and quickly demagnetizes by high resistance R1=10kΩ. In this case, the secondary current of CT1 does not flow through the sampling resistor, and therefore, an output value of the sampling resistor is 0, as the waveform 230 of "CT1 sampling" shown in FIG. 8, that is, CT1 works in a demagnetization mode. However, in this case, when the primary current of CT2 flows out from the dotted terminal, and the secondary current of CT2 flows in from the dotted terminal. If CT2 flows in a backword demagnetization loop, the high resistance R1 of the demagnetization loop is relatively large, which will quickly cause backward magnetic saturation of transformer T2. Therefore, PMOSQ1 needs to be turned on to enable the secondary current to flow through a backward bypass loop formed by PMOSQ1 and the diode D1, thereby achieving backward bypass, bypassing the sampling resistor, and enabling the sampling output zero, as the waveform 230 shown in FIG. 8. During the working process, the switch S1 is an active switch, and the switch S2 is a freewheeling switch. The sampling value of Sa3 is chosen as a sampling current value in a case that the sampling value of Sa3 is greater than the sampling value of Sa1. The sampling value of Sa2 is chosen as a sampling current value in a case that the sampling value of Sa3 is less than the sampling value of Sa1.

When in the negative half cycle, the sampling signal outputted by the sampling resistor of CT1 is a power current value.

Referring to FIG. 3, when the primary side of the current transformer CT and the secondary side of the current transformer CT are connected in non-dotted terminals, for example, the AC-DC works in a forward direction, that is, AC voltage is transferred to DC voltage, and when the voltage of AC is in the positive half cycle, the upper part is positive and the lower part is negative, in an idea case, a current direction of AC is to be shown in FIG. 4 and FIG. 5.

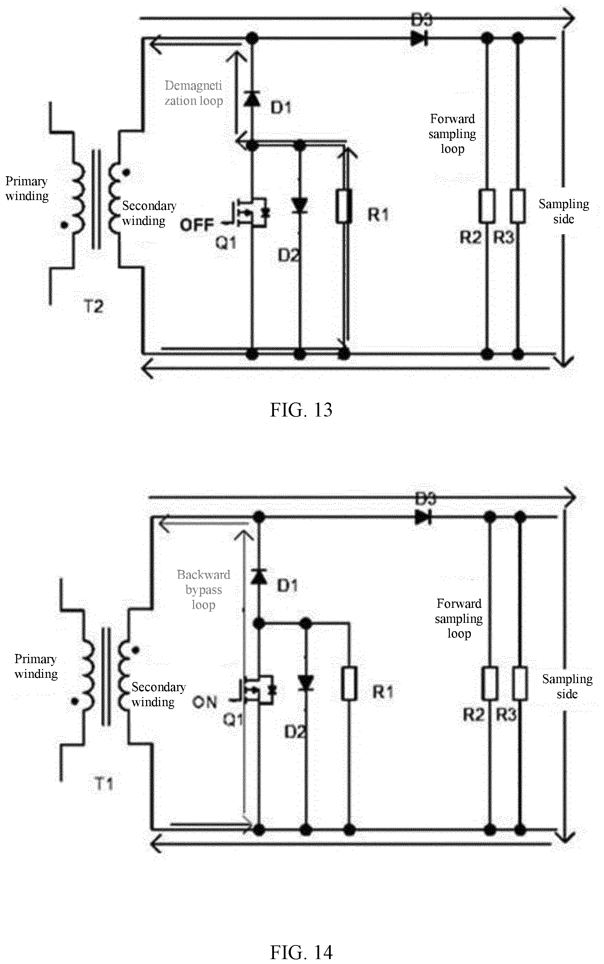

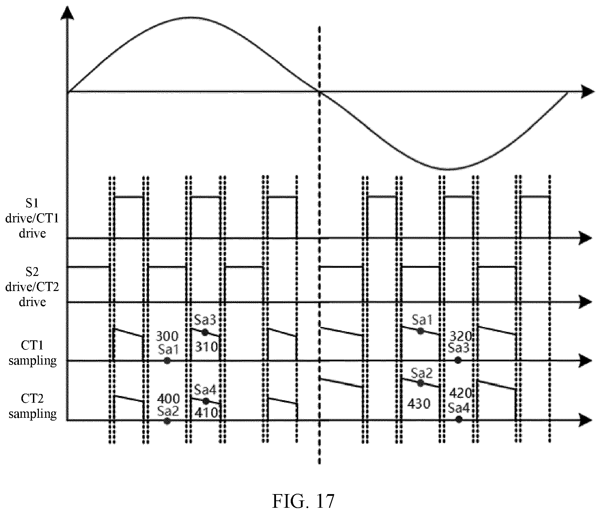

Specifically, when the switch S2 and the switch S4 are turned on, as the current direction shown in FIG. 4, when the primary current of current transformer CT flows out from the dotted terminal of CT2, and the secondary current of CT2 flows in from the dotted terminal. If the secondary current flows in a backword demagnetization loop, the high resistance R1 of the demagnetization loop is relatively large, which will quickly cause backward magnetic saturation of transformer T1. Therefore, PMOSQ1 needs to be turned on to enable the secondary current to flow through a backward bypass loop formed by PMOSQ1 and the diode D1, thereby achieving backward bypass. In this case, the current path of CT2 is shown as the inner side arrow in FIG. 14, and the waveform is shown as the waveform 400 in FIG. 17. In this case, for CT1, the main power does not flow through the switch S1, no current flows through the primary side of CT1, and PMOSQ1 in CT1 is controlled to be turned off. The secondary current of CT1 flows a demagnetization loop, performs backward demagnetization shown as the inner side arrow in FIG. 13, and quickly demagnetizes by high resistance R1=10kΩ. In this case, the secondary current of CT1 does not flow through the sampling resistor, and therefore, an output value of the sampling resistor is 0, as the waveform 300 shown in FIG. 17, that is, CT1 works in a demagnetization mode.

Then, the primary current is commutated, the switch S1 and the switch S4 are turned on, as the current direction shown in FIG. 5, when a primary current of the current transformer CT flows in from the dotted terminal of CT1, a secondary current of CT1 flows out from the dotted terminal, and a current path of CT1 shown as the outermost arrow in FIG. 13, that is, the current flows through a backward sampling loop. A sampling resistor outputs a sampling signal VS1 representing a power current flowing through the switch S1, and for the sampling output signal, reference may be made to a waveform 310 shown in FIG. 17, that is, CT1 works in a forward sampling mode, and in this case, the transformer T1 of CT1 is excited forward. In this case, no current flows through the primary side of CT2, and an excitation current generated by the transformer T2 flows through the secondary side of CT2, and the current path is shown as the outermost arrow in FIG. 14, that is, the current flows through the forward sampling loop. The sampling resistor outputs a sampling signal VS2 representing an excitation current flowing through the transformer T2, and for the sampling output signal, reference may be made to a waveform 410 shown in FIG. 17. During the working process, the switch S2 is an active switch, and the switch S1 is a freewheeling switch. The sampling value of Sa3 is chosen as a sampling current value in a case that the sampling value of Sa3 is greater than the sampling value of Sa1. The sampling value of Sa2 is chosen as a sampling current value in a case that the sampling value of Sa3 is less than the sampling value of Sa1. When in the positive half cycle, the sampling signal outputted by the sampling resistor of CT1 is a power current value.

When the primary side of the current transformer CT and the secondary side of the current transformer CT are non-dotted terminals connected, for example, the AC-DC works in a forward direction, that is, AC voltage is transferred to DC voltage, and when the voltage of AC is in a negative half cycle, the lower part is positive and the upper part is negative, in an idea case, a current direction of AC is to be shown in FIG. 9 and FIG. 10.

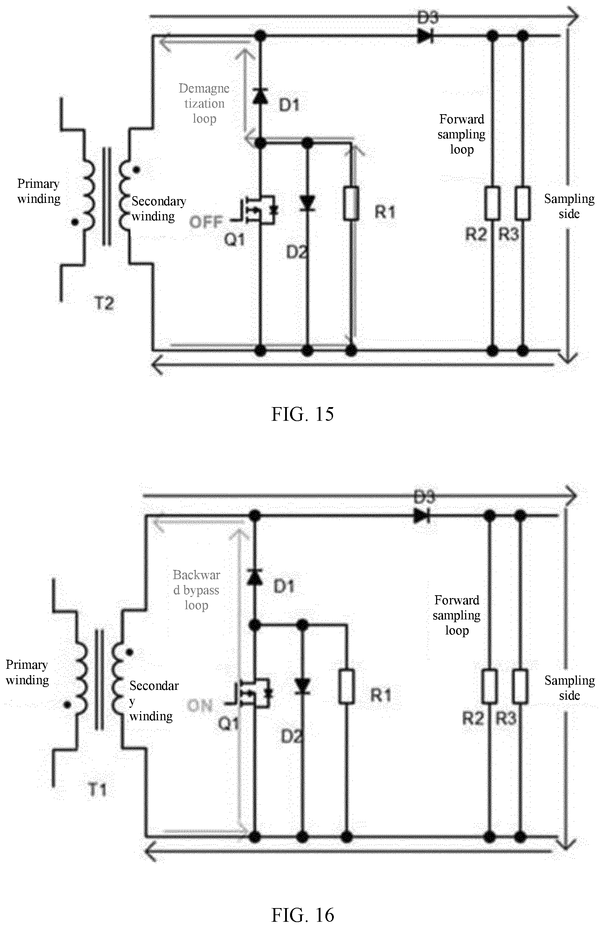

Specifically, when the switch S1 and the switch S3 are turned on, as the current direction shown in FIG. 9, when the primary current of current transformer CT flows out from the dotted terminal of CT1, and the secondary current of CT1 flows in from the dotted terminal. If the secondary current flows in a backword demagnetization loop, the high resistance R1 of the demagnetization loop is relatively large, which will quickly cause backward magnetic saturation of transformer T1. Therefore, PMOSQ1 needs to be turned on to enable the secondary current to flow through a backward bypass loop formed by PMOSQ1 and the diode D1, thereby achieving backward bypass. In this case, the current path of CT1 is shown as the inner side arrow in FIG. 16, and the waveform is shown as the waveform 320 in FIG. 17. In this case, for CT2, the main power does not flow through the switch S2, no current flows through the primary side of CT2, and PMOSQ1 in CT2 is controlled to be turned off. The secondary current of CT2 flows a demagnetization loop, performs backward demagnetization shown as the inner side arrow in FIG. 15, and quickly demagnetizes by high resistance R1=10kΩ. In this case, the secondary current of CT2 does not flow through the sampling resistor, and therefore, an output value of the sampling resistor is 0, as the waveform 420 shown in FIG. 17, that is, CT2 works in a demagnetization mode.

Then, the primary current is commutated, and the switch S2 and the switch S3 are turned on. As the current direction shown in FIG. 10, when a primary current of the current transformer CT flows in from the dotted terminal of CT2, a secondary current of CT2 flows out from the dotted terminal, and a current path of CT2 shown as the outermost arrow in FIG. 15, that is, the current flows through a forward sampling loop. A sampling resistor outputs a sampling signal VS2 representing a power current flowing through the switch S2, and for the sampling output signal, reference may be made to a waveform 430 shown in FIG. 17, that is, CT2 works in a forward sampling mode, and in this case, the transformer T2 of CT2 is excited forward. In this case, no current flows through the primary side of CT1, and an excitation current generated by the transformer T1 flows through the secondary side of CT1, and the current path is shown as the outermost arrow in FIG. 16, that is, the current flows through the forward sampling loop. The sampling resistor outputs a sampling signal VS1 representing an excitation current flowing through the transformer T1, and for the sampling output signal, reference may be made to a waveform 320 shown in FIG. 17. During the working process, the switch S1 is an active switch, and the switch S2 is a freewheeling switch. The sampling value of Sa2 is chosen as a sampling current value in a case that the sampling value of Sa2 is greater than the sampling value of Sa4. The sampling value of Sa3 is chosen as a sampling current value in a case that the sampling value of Sa2 is less than the sampling value of Sa4.

When in the negative half cycle, the sampling signal outputted by the sampling resistor of CT2 is a power current value.

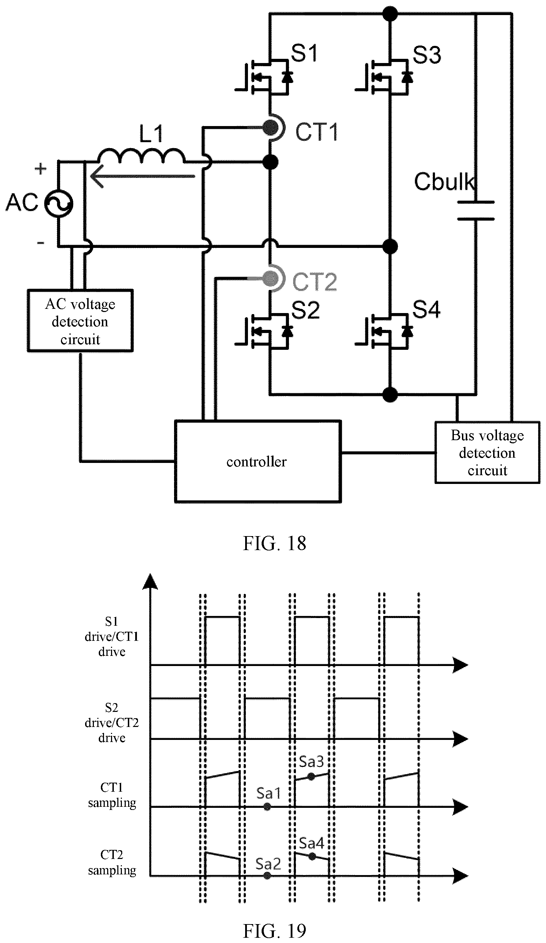

For example, the AC-DC works in a backward direction, that is, DC voltage is transferred to AC voltage, and when the voltage of AC is in a positive half cycle, and the switching process is that, the switch S1 and the switch S4 are turned on to work, and the switch S2 and the switch S4 are turned on to freewheel, the upper part is positive and the lower part is negative. In an idea case, an AC current direction is to be shown in FIG. 18. The working waveform is as shown in FIG. 19, and its principle is similar to its forward working principle, and details are not repeated herein.

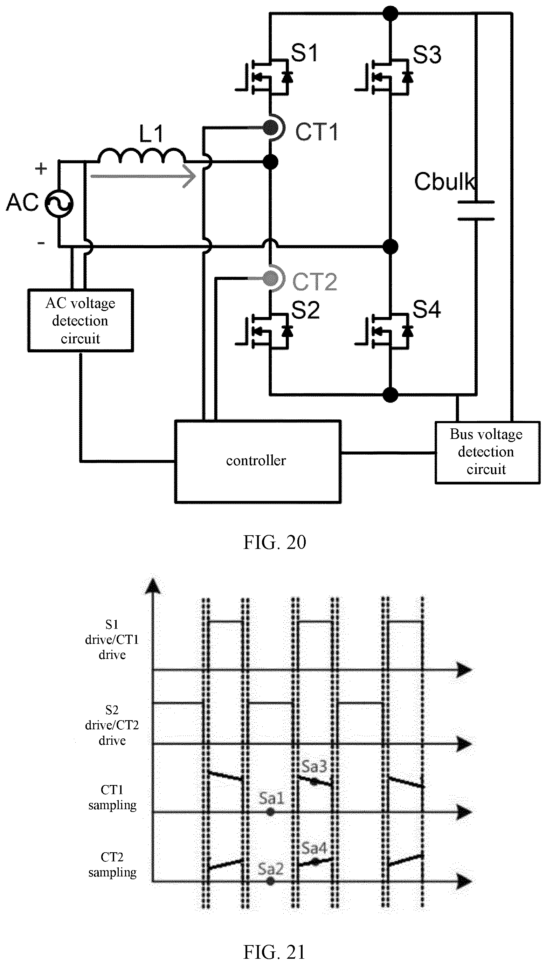

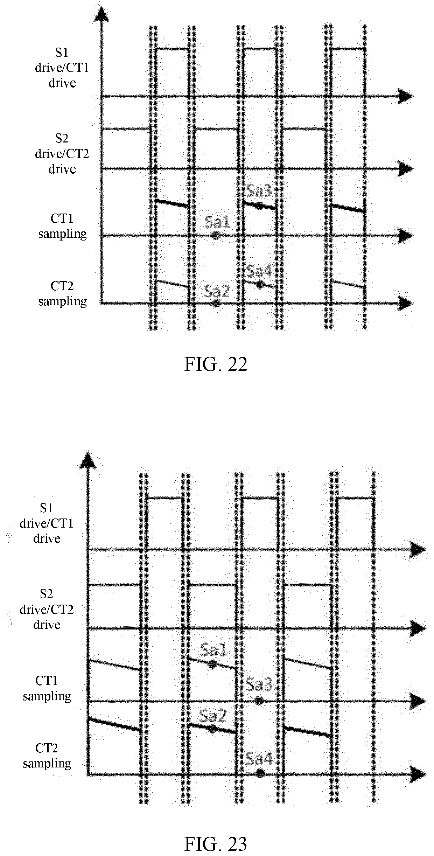

For example, the AC-DC works in a backward direction, that is, DC voltage is transferred to AC voltage, and when the voltage of AC is in a negative half cycle, and the switching process is that, the switch S2 and the switch S3 are turned on to work, and the switch S1 and the switch S4 are turned on to freewheel, the upper part is negative and the lower part is positive. In an idea case, an AC current direction is to be shown in FIG. 20. The working waveform is as shown in FIG. 23, and its principle is similar to its forward working principle, and details are not repeated herein.

As described above, only when the main power current flows in from the dotted terminal of the primary side of the current transformer CT, a signal effectively reflecting the main power current can be detected at a sampling side. However, in the same switch cycle, CT1 and CT2 will output sampling signals at the same time, as the waveform 100 and the waveform 200 shown in FIG. 8. Only one of the sampling values in CT1 and CT2 can effectively reflecting the actual main power current value, for example, only the waveform 200 and the waveform 120 in FIG. 8 can effectively reflect the actual main power current value. However, we cannot know an actual inductive current direction in advance, so after obtaining the sampling values of CT1 and CT2, we need to screen out the effective sampling values reflecting the actual main power current values. As shown in FIG. 8, the waveform 200 needs to be selected from the waveform 100 and the waveform 200, and the waveform 120 needs to be selected from the waveform 120 and the waveform 220.

When the dotted terminals of the current transformer CT are connected, for example, the AC-DC works in a forward direction, and when the voltage of AC is in a positive half cycle, the upper part is positive and the lower part is negative. Each of CT1 and CT2 is sampled for one time at the driving midpoint of the switch S1 and the switch S2, to obtain four sampling points of Sa1, Sa2, Sa3, and Sa4. Sa1 and Sa3 correspond to the first current detection circuit, and Sa2 and Sa4 correspond to the second current detection circuit.

By comparing the sampling data situations at the driving midpoint of the switch S1 and the driving midpoint of the switch S2, a current transformer CT signal is selected to be used as a forward channel current signal to control, and an inductive current direction in this switch cycle is determined. As shown in FIG. 8, in the positive half cycle, the active switch is the switch S2, and then the sampling value of Sa2 and the sampling value of Sa4 of the sampling results of CT2 are compared. If the sampling value of Sa2 is greater than the sampling value of Sa4, the sampling value of Sa2 is used as a current value of L1. If the sampling value of Sa2 is less than the sampling value of Sa4, the negative half cycle is entered, and the sampling value of Sa3 is used as a current value of L1.

Referring to FIG. 22 and FIG. 23, when the dotted terminals are connected, for example, the AC-DC works in a backward direction, and when the voltage of AC is in a positive half cycle, the upper part is positive and the lower part is negative. Each of CT1 and CT2 is sampled for one time at the driving midpoint of S1 and S2, to obtain four sampling points of Sa1, Sa2, Sa3, and Sa4.

By comparing the sampling data situations at the driving midpoint of the switch S1 and the driving midpoint of the switch S2, a current transformer CT signal is selected to be used as a forward channel current signal to control, and an inductive current direction in this switch period is determined. When the active switch is the switch S1, the sampling value of Sa1 and the sampling value of Sa3 of the sampling results of CT1 are compared. If the sampling value of Sa3 is greater than the sampling value of Sa1, the sampling value of Sa3 is used as a current value of L1. If the sampling value of Sa3 is less than the sampling value of Sa1, the negative half cycle is entered, and the sampling value of Sa2 is used as a current value of L1.

When the non-dotted terminals of the current transformer CT are connected, for example, the AC-DC works in a forward direction, and when the voltage of AC is in a positive half cycle, the upper part is positive and the lower part is negative. Each of CT1 and CT2 is sampled for one time at the driving midpoint of the switch S1 and the switch S2, to obtain four sampling points of Sa1, Sa2, Sa3, and Sa4.

By comparing the sampling data situations at the driving midpoint of the switch S1 and the driving midpoint of the switch S2, a current transformer CT signal is selected to be used as a forward channel current signal to control, and an inductive current direction in this switch period is determined. As shown in FIG. 17, in the positive half cycle, the active switch is the switch S2, and the freewheeling switch is the switch S1, and the sampling value of Sa1 and the sampling value of Sa3 of the sampling results of CT1 are compared. If the sampling value of Sa3 is greater than the sampling value of Sa1, the sampling value of Sa3 is used as a current value of L1. If the sampling value of Sa3 is less than the sampling value of Sa1, the negative half cycle is entered, and the sampling value of Sa2 is used as a current value of L1.

When the non-dotted terminals are connected and the AC-DC works in a backward direction, the working principles are as described above, and details are not repeated.

## Claims

1. A current sampling circuit applied to a bidirectional AC-DC converter, comprising:
a totem-pole PFC circuit, comprising a fast-switch bridge arm formed by a switch S1 and a switch S2 connected in series;
a first current detection circuit, comprising a first current transformer CT, a first demagnetization circuit, and a first current sampling unit that are successively connected, wherein the first current sampling unit outputs a first sampling signal VS1, the first current transformer CT is a transformer T1, and a primary winding of the transformer T1 is connected in series with the switch S1;
a second current detection circuit, comprising a second current transformer CT, a second demagnetization circuit, and a second current sampling unit that are successively connected, wherein the second current sampling unit outputs a second sampling signal VS2, the second current transformer CT is a transformer T2, and a primary winding of the transformer T2 is connected in series with the switch S2; and
a controller, connecting the first current sampling circuit and the second current sampling circuit to receive the first sampling signal VS1 and the second sampling signal VS2, wherein in one switching cycle, the controller obtains sampling points Sa1, Sa2, Sa3, and Sa4 and four corresponding sampling values by sampling the first current detection circuit and the second current detection circuit for one time at a driving midpoint of the switches S1 and S2; and Sa1 and Sa3 correspond to the first current detection circuit, and Sa2 and Sa4 correspond to the second current detection circuit.

2. The current sampling circuit applied to a bidirectional AC-DC converter according to claim 1, wherein the controller performs the following steps: determining a sampling value of an active switch in a case that the transformer T1 and the transformer T2 are connected in dotted terminals, and the active switch is the switch S2 in a case that an AC voltage is in a positive half cycle, choosing the sampling value of Sa2 as a sampling current value in a case that the sampling value of Sa2 is greater than the sampling value of Sa4; choosing the sampling value of Sa3 as a sampling current value in a case that the sampling value of Sa2 is less than the sampling value of Sa4; the active switch is the switch S1 in a case that an AC voltage is in a negative half cycle, choosing the sampling value of Sa3 as a sampling current value in a case that the sampling value of Sa3 is greater than the sampling value of Sa1; choosing the sampling value of Sa2 as a sampling current value in a case that the sampling value of Sa3 is less than the sampling value of Sa1;
determining a sampling value of a freewheeling switch in a case that the transformer T1 and the transformer T2 are connected in non-dotted terminals, and the freewheeling switch is the switch S1 in a case that an AC voltage is in a positive half cycle, choosing the sampling value of Sa3 as a sampling current value in a case that the sampling value of Sa3 is greater than the sampling value of Sa1; choosing the sampling value of Sa2 as a sampling current value in a case that the sampling value of Sa3 is less than the sampling value of Sa1; the freewheeling switch is the switch S2 in a case that an AC voltage is in a negative half cycle, choosing the sampling value of Sa2 as a sampling current value in a case that the sampling value of Sa2 is greater than the sampling value of Sa4; and choosing the sampling value of Sa3 as a sampling current value in a case that the sampling value of Sa2 is less than the sampling value of Sa4.

3. The current sampling circuit applied to a bidirectional AC-DC converter according to claim 2, wherein both of the first demagnetization circuit and the second demagnetization circuit comprising a diode D1, a PMOSQ1, a diode D2, and a resistor R1, in the first demagnetization circuit, the source of the PMOSQ1, the positive electrode of the diode D2, and one end of the resistor R1 are connected to the positive electrode of the diode D1; the drain of the PMOSQ1, the negative electrode of the diode D2, and the other end of the resistor R1 are connected to one end of a secondary winding of the transformer T1; and the negative electrode of the diode D1 is connected to the other end of the secondary winding of the transformer T1; and in the second demagnetization circuit, the source of the PMOSQ1, the positive electrode of the diode D2, and one end of the resistor R1 are connected to thepositive electrode of the diode D1; the drain of the PMOSQ1, the negative electrode of the diode D2, and the other end of the resistor R1 are connected to one end of the secondary winding of the transformer T2; and the negative electrode of the diode D1 is connected to the other end of the secondary winding of the transformer T2.

4. The current sampling circuit applied to a bidirectional AC-DC converter according to claim 3, wherein both of the first current sampling unit and the second current sampling unit comprising a diode D3, a resistor R2, and a resistor R3, one end of the resistor R2 and one end of the resistor R3 are connected to the negative electrode of the diode D3, in the first current sampling circuit, the other end of the resistor R2 and the other end of the resistor R3 are connected to one end of the secondary winding of the transformer T1, and the positive electrode of the diode D3 is connected to the other end of the secondary winding of the transformer T1, and in the second current sampling circuit, the other end of the resistor R2 and the other end of the resistor R3 are connected to one end of the secondary winding of the transformer T2, and the positive electrode of the diode D3 is connected to the other end of the secondary winding of the transformer T2.

5. The current sampling circuit applied to a bidirectional AC-DC converter according to claim 2, wherein the totem-pole PFC circuit comprising an inductor L1, a switch S3, a switch S4, a capacitor Cbulk, and an alternating current power supply AC, one end of the alternating current power supply AC is connected to one end of the inductor L 1, and the other end of the inductor L1 is connected to the source of the switch S1 and the drain of the switch S2, the drain of the switch S1 is connected to the drain of the switch S3 and one end of the capacitor Cbulk, and the other end of the capacitor Cbulk is connected to the source of the switch S2 and the source of the switch S4, and the source of the switch S3 and the drain of the switch S4 are connected to the other end of the alternating current power supply AC.

6. The current sampling circuit applied to a bidirectional AC-DC converter according to claim 5, further comprising an AC voltage detection circuit, wherein the AC voltage detection circuit is connected to two ends of the alternating current power supply to detect voltages at the two ends of the alternating current power supply, and transmit the voltages at the two ends of the alternating current power supply to the controller.

7. The current sampling circuit applied to a bidirectional AC-DC converter according to claim 5, further comprising a bus voltage detection circuit, wherein the bus voltage detection circuit is connected to two ends of the capacitor Cbulk to detect voltages at the two ends of the capacitor Cbulk, and transmit the voltages at the two ends of the capacitor Cbulk to the controller.

8. The current sampling circuit applied to a bidirectional AC-DC converter according to claim 4, wherein the current sampling circuit operates in a current sampling mode, and the secondary winding of the current transformer, the diode D3, and the current sampling unit form a current loop.

9. The current sampling circuit applied to a bidirectional AC-DC converter according to claim 4, wherein the current sampling circuit operates in a bypass mode, and the secondary winding of the current transformer, the PMOSQ1, and diode D1 form a current loop.

10. The current sampling circuit applied to a bidirectional AC-DC converter according to claim 4, wherein the current sampling circuit operates in a demagnetization mode, and the secondary winding of the current transformer, the resistor R1, and diode D1 form a current loop.
